# EUROPÄISCHE PATENTSCHRIFT

(11) **EP 0 339 065 B1**
(45) Veröffentlichungstag und Bekanntmachung des Hinweises auf die Patenterteilung: **07.01.1993**
(21) Anmeldenummer: 88909292.0
(22) Anmeldetag: 26.10.1988
(51) Int. Cl.: C23C 26/02, C23C 4/18

(54) **VERFAHREN ZUR HERSTELLUNG VON SCHICHTEN**
PROCESS FOR MANUFACTURING LAYERS
PROCEDE DE FABRICATION DE STRATES

(30) Priorität: 29.10.1987 DE 3736661
(43) Veröffentlichungstag der Anmeldung: 02.11.1989
(73) Patentinhaber: MTU MOTOREN- UND TURBINEN-UNION MÜNCHEN GMBH, D-80976 München (DE)
(72) Erfinder: GRUNKE, Richard, D-8000 München 70 (DE)
(86) Internationale Anmeldenummer: DE8800660
(87) Internationale Veröffentlichungsnummer: WO8903900

(56) Entgegenhaltungen:
- EP-A- 0 098 085
- EP-A- 0 236 520
- Metal Abstracts, vol. 13, no. 2, Feb. 1980, London, GB; page 245, No. 72-0118
- Chemical Abstracts, vol. 92, No. 22, 2 June 1980, Columbus, Ohio, US; K.K. Schweitzer et al.: "Space processing of turbine blades by means of skin technology", page 204, abstract 184 465j

## Beschreibung

Die Erfindung betrifft ein Verfahren zur Herstellung von Schichten oder Bauteilen mittels Schwerelosigkeit durch Aufbringen eines Werkstoffs auf eine Form.

Aus Metals Abstracts, Band13, Nr2, Februar 1980, (London GB), Seiten 245ff, von P.Leven et al.: "Quality improvement for space-processed turbine blades" ist ein Verfahren bekannt, bei dem ein Werkstoff auf einen Kern aufgebracht wird, mit einer formerhaltenden Beschichtung umgeben wird und ein Bauteil unter Schwerelosigkeit innerhalb einer geschlossenen Form aus einer formerhaltenden Beschichtung erschmolzen oder gesintert wird. Dieses Verfahren hat den Nachteil, daß die geschlossene Form nicht zerstörungsfrei entfernt werden kann und damit ein kostengünstiger Mehrfacheinsatz beispielsweise als Matrize zur Herstellung dünnwandiger und großflächiger Bauteile nicht einsetzbar ist.

Kompliziert geformte, dünnwandige, großflächige Bauteile wie beispielsweise Gasturbinenbrennkammern können bisher nur aus schmiedbaren Legierungen hergestellt werden. Die erforderliche Schmiedbarkeit der verwendeten Legierungen bedingt jedoch, daß deren Warmfestigkeit eingeschränkt ist, und daher die Einsatzmöglichkeiten bei hohen Temperaturen beschränkt sind, bzw. umfangreiche und aufwendige Kühlmaßnahmen vorzusehen sind.

Bisher nicht verwendbar sind zudem dispersionsgehärtete Legierungen, Verbundwerkstoffe aus Metallmatrix und Keramikpartikeln (Cermets), faserverstärkte Metalle (FVM) oder gerichtet erstarrte Eutektika (GEE).

Eine gießtechnische Herstellung derartiger Bauteile, die eine erhöhte Warmfestigkeit mit sich bringen würde, ist mit herkömmlichen Verfahren nicht möglich. Beispielsweise wirkt sich die unzureichende Ausfüllung der Gießform durch die Schmelze und die Schrumpfung nachteilig aus.

Aufgabe der Erfindung ist die Schaffung eines Verfahrens, durch welches kompliziert geformte, dünnwandige und großflächige Bauteile oder Schichten aus hochwarmfesten Gußlegierungen herstellbar sind. Weiterhin ist es Aufgabe, die Legierungszusammensetzung von Bauteilen ohne Rücksicht auf die Schmiedbarkeit einzustellen, bzw. Cermets, FVM oder GEE einzusetzen. Weiterhin ist es Aufgabe, keramische Schichten auf dem Bauteil zu sintern.

Erfindungsgemäß wird die Aufgabe dadurch gelöst, daß der Werkstoff auf eine offene Form in dünner Schicht unter Schwerelosigkeit aufgeschmolzen wird und man ihn einseitig formfrei erstarren läßt.

Das erfindungsgemäße Verfahren bringt den Vorteil mit sich, daß die auf der Wand der offenen Form aufgebrachte Werkstoffschicht in gleichmäßiger Schichtstärke erstarrt. Der Werkstoff wird vorteilhafterweise bei der Aufschmelzung mittels Adhäsion an der Formwand gehalten ohne abzulaufen, wie dies unter Gravitationsbedingungen der Fall sein würde.

Es lassen sich vorteilhafterweise durch das erfindungsgemäße Verfahren bei geeigneter Werkstoffauswahl bzw. Herstellung besonders dünner Wandungen Gewichtseinsparungen erzielen und wiederum als Folge davon bzw. aufgrund der höheren Temperaturbelastbarkeit sind Wirkungsgradverbesserungen erzielbar. Vorzugsweise kann vor dem Aufbringen des Werkstoffs die Form auf Schmelztemperatur erhitzt oder mit Haftschicht versehen oder ihre Oberfläche aktiviert werden, womit vorteilhaft die Besetzüngseigenschaften der offenen Form verbessert werden können.

Die Aufbringung des Werkstoffes auf die offene Form kann mittels Flamm- oder Plasmaspritzen, Schlickerguß oder galvanischer Abscheidung erfolgen, wobei dies unter Schwerkraftbedingungen oder unter Schwerelosigkeit durchgeführt werden kann.

Dabei besteht bei einer bevorzugten Ausführungsform das Bauteil aus einem Werkstoff, in dessen Gußstrukturen Teilchen gleichmäßig dispergiert sind, hierdurch ist ebenfalls eine höhere Warmfestigkeit und Oxidationsbeständigkeit erzielbar.

Es können in bevorzugter Ausführungsform nacheinander Schichten mit unterschiedlichen Werkstoffen aufgebracht werden. Beispielsweise ist eine homogene Gußschicht mit einer aus Keramikpartikeln bestehenden Wärmedämmschicht herstellbar, wobei neben vereinfachter Herstellung eine gute Schichthaftung erreichbar ist.

Beispielsweise durch Rücksputtern oder Oxidstrahlen wird vorzugsweise die Formoberfläche aktiviert, um eine Benetzung der Form durch die Schmelze zu gewährleisten. Formflächen, die nicht von der Schmelze bedeckt werden sollen, werden im Bedarfsfall passiviert.

Vorzugsweise wird das Bauteil nach dem Aufschmelzen einem Zonenschmelzen unter Vakuum unterzogen, wodurch sich eine Einkristallstruktur, oder eine gerichtet erstarrte eutektische Struktur des Bauteiles erzeugen läßt.

Durch die Aufbringung von Keramik und Metall in Pulverform oder faserverstärkter Metalle lassen sich neben den bereits erwähnten Vorteilen Gewichtseinsparungen erzielen.

Die Erfindung wird nachfolgend anhand von Beispielen und den beigefügten Zeichnungen weiter erläutert.

### Beispiel 1:

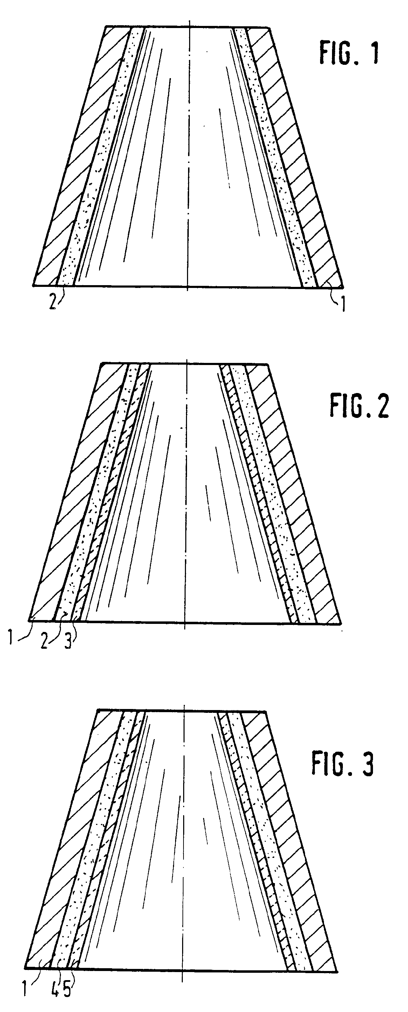

Ein mittels Plasmaspritzen von reinmetallischem Werkstoffpulver hergestelltes Bauteil 2 wird an der Form 1 belassen (Fig. 1). Die Innenfläche soll mit einer Wärmedämmschicht versehen werden. Eine geeignete Keramik 3, z. B. ZrO₂, wird durch Plasmaspritzen oder als Schlicker, beispielsweise nach der DE-PS 25 50 839, durch Tauchen auf die Innenfläche des Bauteils 2 aufgebracht (Fig. 2). Die Keramikschicht 3 wird gesintert, wobei der Grundwerkstoff unter Schwerelosigkeit erweicht oder schmilzt, aber durch Adhaesionskräfte an der Form 1 gehalten wird. Durch den Sinterprozeß erreicht die Wärmedämmschicht optimale Festigkeit, durch das Aufschmelzen des Grundwerkstoffes unter Schwerelosigkeit wird eine optimale Haftung zwischen Schicht und Grundwerkstoff erreicht. Um eine Benetzung der Keramikpartikel durch den Grundwerkstoff zu erreichen, wird das Pulver vor Aufbringung aktiviert.

### Beispiel 2:

In einer Form wird zunächst durch Metallschlicker ein Scherben 4 gebildet (Fig. 3). Darauf wird in einem Keramikschlicker die Wärmedämmschicht 5 "aufgeschlämmt" (Fig. 3). Beim Aufheizen schmilzt unter Schwerelosigkeit zunächst das Metallpulver, dann sintert die Keramikschicht.

### Beispiel 3:

Für die Herstellung einer Heißgasführung für eine Gasturbine wird zunächst eine offene Keramikform hergestellt. Auf die äußere Formwand wird eine Kobalt-Gußlegierung folgender Zusammensetzung mittels Plasmaspritzen aufgebracht:
- Ni: 10,5 % (Angaben jeweils Gewichts-%)
- Cr: 25,5 %
- Ta: 7,5 %
- Mn: 0,75 %
- Si: 0,75 %
- B: 0,50 %
- Co: Rest

Es wird eine Schichtdicke von 0,5 mm aufgetragen. Die offene Form mit der Spritzschicht wird unter Schwerelosigkeit im Vakuumofen aufgeheizt. Bei Erreichen der Schmelztemperatur des aufgespritzten Werkstoffes (1.350 - 1.400 °C) schmilzt die Spritzschicht auf, wobei die Schmelze durch Adhäsion an der Formwand gehalten wird. Nach Abkühlung und Erstarrung der Schmelze werden Form und Bauteil getrennt. Dies geschieht beispielsweise mittels chemischem Auflösen. Das Bauteil besteht aus Kobaltwerkstoff mit homogener Gußstruktur.

## Patentansprüche

1. Verfahren zur Herstellung von Schichten oder Bauteilen (2) mittels Schwerelosigkeit durch Aufbringen eines Werkstoffs auf eine Form, dadurch gekennzeichnet, daß der Werkstoff in dünner Schicht auf einer offenen Form unter Schwerelosigkeit aufgeschmolzen wird und man ihn einseitig formfrei erstarren läßt.

2. Verfahren nach Anspruch 1, dadurch gekennzeichnet, daß die Form vor dem Aufbringen des Werkstoffes auf Schmelztemperatur erhitzt wird.

3. Verfahren nach einem oder mehreren der Ansprüche 1 oder 2, dadurch gekennzeichnet, daß die Form vor Aufbringung des Werkstoffes mit einer Haftschicht versehen wird.

4. Verfahren nach Anspruch 1 bis 3, dadurch gekennzeichnet, daß mehrere Schichten unterschiedlicher Werkstoffe nacheinander aufgebracht werden.

5. Verfahren nach Anspruch 1 bis 4, dadurch gekennzeichnet, daß die Oberfläche der Form vor Aufbringung des Werkstoffes aktiviert wird.

6. Verfahren nach Anspruch 5, dadurch gekennzeichnet, daß die Aktivierung mittels Rücksputtern oder Oxidstrahlen geschieht.

7. Verfahren nach Anspruch 1 bis 6, dadurch gekennzeichnet, daß die nicht vom Werkstoff zu benetzenden Oberflächenbereiche der Form (1) vor Aufbringung des Werkstoffes passiviert werden.

8. Verfahren nach einem oder mehreren der vorhergehenden Ansprüche, dadurch gekennzeichnet, daß die Form (1) aus Keramik besteht.

9. Verfahren nach Anspruch 1 bis 8, dadurch gekennzeichnet, daß die Aufschmelzung unter Vakuum erfolgt.

10. Verfahren nach einem oder mehreren der vorhergehenden Ansprüche, dadurch gekennzeichnet, daß mittels Zonenschmelzen unter Vakuum eine Einkristallstruktur oder gerichtete eutektische Erstarrung erzeugt wird.

## Claims

1. Process for manufacturing layers or components (2) by means of zero gravity by depositing a material onto a mould, characterised in that the material is melted in a thin layer onto an open mould under zero gravity and is left to harden from the side away from the mould.

2. Process according to Claim 1,
characterised in that the mould is heated to melting temperature before the material is deposited.

3. Process according to either of Claims 1 or 2, characterised in that the mould is provided with an adhesive layer before the material is deposited.

4. Process according to any one of Claims 1 to 3, characterised in that a plurality of layers of different materials is deposited in succession.

5. Process according to any one of Claims 1 to 4, characterised in that the surface of the mould is activated before the material is deposited.

6. Process according to Claim 5,
characterised in that the surface is activated by means of back sputtering or oxide radiation.

7. Process according to any one of Claims 1 to 6, characterised in that the surface areas of the mould (1) not to be wetted by the material are passivated before the material is deposited.

8. Process according to one or more of the preceding claims, characterised in that the mould (1) is made from ceramics.

9. Process according to any one of Claims 1 to 8, characterised in that the melting-on process occurs under vacuum.

10. Process according to one or more of the preceding claims, characterised in that a single crystal structure or directed eutectic hardening is achieved by means of localised melting under vacuum.

## Revendications

1. Procédé pour la production de couches ou de composant (2) au moyen de faible solubilité, par application d'un matériau sur un moule, caractérisé en ce que le matériau est fondu en couche mince sur un moule ouvert, avec faible solubilité, et on le laisse durcir d'un côté sans moule.

2. Procédé selon la revendication 1, caractérisé en ce que, avant l'application du matériau, le moule est chauffé à la température de fusion.

3. Procédé selon la revendication 1 ou 2, caractérisé en ce que, avant l'application du matériau, le moule est muni d'une couche d'adhérence.

4. Procédé selon l'une des revendications 1 à 3, caractérisé en ce que plusieurs couches de matériaux différents sont appliquées successivement.

5. Procédé selon l'une des revendications 1 à 4, caractérisé en ce que, avant l'application du matériau, la surface du moule est activée.

6. Procédé selon la revendication 5, caractérisé en ce que l'activation est effectuée au moyen de rétropulvérisation cathodique ou de projection d'oxydes.

7. Procédé selon l'une des revendications 1 à 6, caractérisé en ce que les parties superficielles du moule (1), non destinées à être mouillées par le matériau, sont passivées avant l'application du matériau.

8. Procédé selon une ou plusieurs des revendications précédentes, caractérisé en ce que le moule (1) est constitué de céramique.

9. Procédé selon l'une des revendications 1 à 8, caractérisé en ce que la fusion s'effectue sous vide.

10. Procédé selon une ou plusieurs des revendications précédentes, caractérisé en ce que l'on engendre une structure monocristalline ou une solidification eutectique dirigée, par fusion par zones sous vide.
